(19) Europäisches Patentamt
European Patent Office
Office européen des brevets

(11) **EP 1 740 962 B1**

(12) **FASCICULE DE BREVET EUROPEEN**

(45) Date de publication et mention de la délivrance du brevet:
**17.02.2010 Bulletin 2010/07**

(21) Numéro de dépôt: **05743142.1**

(22) Date de dépôt: **20.04.2005**

(51) Int Cl.:
***G01R 29/02*** $^{(2006.01)}$

(86) Numéro de dépôt international:
**PCT/EP2005/051755**

(87) Numéro de publication internationale:
**WO 2005/103739 (03.11.2005 Gazette 2005/44)**

(54) **PROCEDE ET DISPOSITIF DE MESURE AVEC DETECTION SYNCHRONE ET ECHANTILLONNAGE CORRELE**

VERFAHREN UND EINRICHTUNG ZUR MESSUNG MIT ASYNCHRONER DETEKTION UND KORRELIERTER ABTASTUNG

METHOD AND DEVICE FOR MEASURING WITH SYNCHRONOUS DETECTION AND CORRELATED SAMPLING

(84) Etats contractants désignés:
**BE DE FI FR GB IT**

(30) Priorité: **27.04.2004 FR 0404458**

(43) Date de publication de la demande:
**10.01.2007 Bulletin 2007/02**

(73) Titulaire: **E2V Semiconductors**
**38120 Saint Egreve (FR)**

(72) Inventeurs:
• **Masson, Thierry**
**F-94117 Arcueil (FR)**
• **Salvi, Fabrice**
**F-94117 Arcueil (FR)**

(74) Mandataire: **Guérin, Michel et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A- 4 262 258**

• **PATENT ABSTRACTS OF JAPAN vol. 2003, no. 05, 12 mai 2003 (2003-05-12) & JP 2003 018477 A (CHINON IND INC), 17 janvier 2003 (2003-01-17)**
• **PATENT ABSTRACTS OF JAPAN vol. 2003, no. 09, 3 septembre 2003 (2003-09-03) & JP 2003 134405 A (SHARP CORP), 9 mai 2003 (2003-05-09)**

## Description

L'invention concerne les circuits électroniques de mesure de signaux faibles dont le niveau de référence est d'une part mal connu et d'autre part sujet à des fluctuations fortes.

L'application typique envisagée est la suivante : mesure de coefficient de transmission ou réflexion lumineuse d'un milieu traversé par la lumière, à l'aide d'une cellule photoémissive et une cellule photosensible, ou mesure des variations de ce coefficient de transmission ou réflexion. En présence d'un éclairement ambiant de luminosité inconnue et variable, voire même un éclairement ambiant bien supérieur en intensité à l'éclairement issu de la cellule photoémissive, on comprend que la mesure est difficile.

Pour s'affranchir de cet inconvénient, on effectue une mesure synchrone : la cellule photoémissive émet des impulsions lumineuses périodiques et on observe le signal reçu par la cellule photosensible pendant les instants d'émission ; de plus on effectue une mesure différentielle à deux instants différents, à savoir juste avant le début de l'impulsion et juste avant la fin de l'impulsion. La différence des signaux mesurés représente bien un surcroît d'éclairement spécifiquement dû à la lumière issue de la cellule photoémissive et ayant traversé le milieu à mesurer.

Cette mesure différentielle est appelée « double échantillonnage corrélé » lorsque les signaux sont mesurés à l'aide d'un échantillonneur-bloqueur. Un échantillonneur-bloqueur est utilisé notamment lorsque le signal issu de la mesure, obtenu sous forme analogique (c'est le cas pour une cellule photosensible), doit être converti en valeur numérique par un convertisseur analogique-numérique. Dans ce cas, l'échantillonneur-bloqueur est conçu pour faire directement un mesure différentielle, c'est-à-dire qu'il fournit directement une valeur de tension électrique représentant non pas chaque mesure d'éclairement mais la différence entre les mesures faites juste avant le début de l'impulsion et juste avant la fin de l'impulsion.

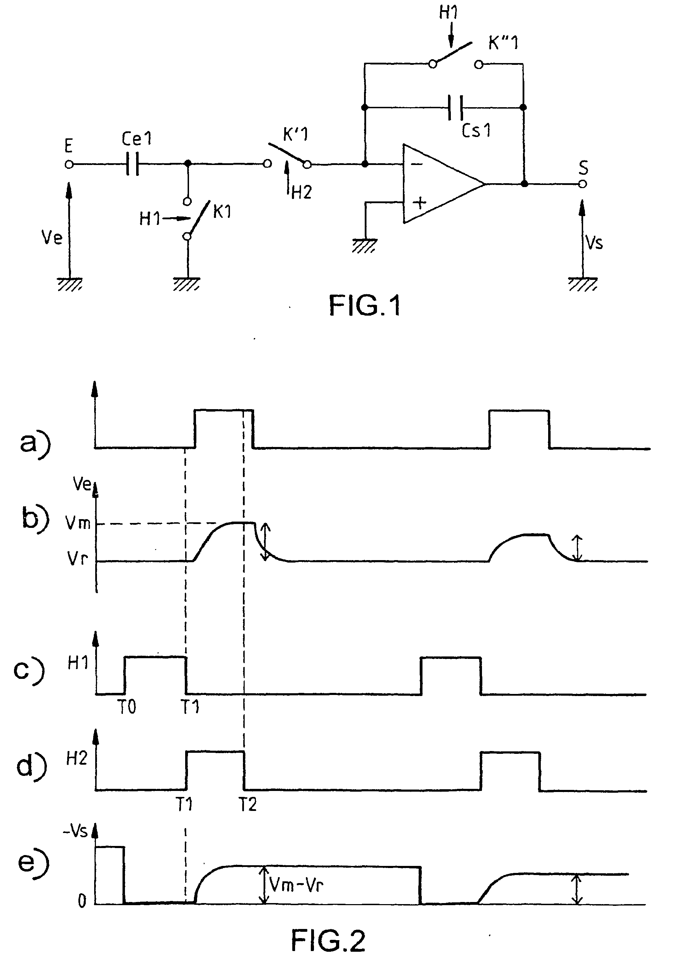

La figure 1 représente un exemple de schéma de principe d'un échantillonneur-bloqueur capable de faire cette mesure différentielle directe. L'entrée E reçoit le signal de mesure Ve (par exemple un signal issu d'une cellule photosensible) qui est égal à un niveau de référence Vr, représentant l'éclairement ambiant, inconnu, qui existe en dehors des impulsions lumineuses. L'entrée E est reliée à une première borne d'une capacité d'entrée Ce1 dont une deuxième borne peut être reliée soit à la masse par un interrupteur K1 soit à l'entrée inverseuse (-) d'un amplificateur opérationnel AMP par un interrupteur K'1. L'amplificateur opérationnel, à grand gain et grande impédance d'entrée, a son entrée non inverseuse (+) reliée à la masse et ses deux entrées sont considérées comme virtuellement au potentiel de la masse. Une capacité d'intégration Cs1 est reliée entre l'entrée inverseuse et la sortie S de l'amplificateur opérationnel. Un interrupteur K"1 permet de court-circuiter la capacité d'intégration Cs1 pour la décharger périodiquement.

Les interrupteurs K1 et K"1 sont fermés en même temps que l'interrupteur K'1 est ouvert, pendant une phase d'initialisation H1 qui se termine juste avant l'impulsion lumineuse émise par la cellule photoémissive. La capacité d'entrée Ce1 se charge alors à la tension de référence Ve= Vr présente à l'entrée juste avant l'impulsion lumineuse ; la capacité d'intégration Cs1 est complètement déchargée. Puis les interrupteurs K1 et K"1 sont ouverts et l'interrupteur K'1 est fermé pendant une phase d'échantillonnage H2 suivant la phase d'initialisation. Pendant cette phase H2, l'impulsion lumineuse est émise. La phase d'échantillonnage se termine avant la fin de l'impulsion lumineuse mais seulement lorsque le signal de la cellule photoélectrique est stabilisé. La tension Ve sur l'entrée E est alors Vm, différente de Vr en raison de l'impulsion lumineuse.

Du fait de la conservation des charges sur les armatures réunies et isolées des capacités Ce1 et Cs1 (charge totale Ce1Vr), les charges se répartissent dans la capacité Ce1 et la capacité Cs1, et, du fait du maintien virtuel à la masse du potentiel de l'entrée inverseuse de l'amplificateur, le potentiel pris par la sortie S est $Vs = -Ce1(Vm-Vr)/Cs1$

Ce potentiel de sortie Vs est donc égal à l'opposé de Vm-Vr si Ce1 et Cs1 sont égales, ou proportionnel à -(Vm-Vr) dans le cas contraire.

Le potentiel de sortie Vs est maintenu ensuite pendant une phase de blocage (après la fin du créneau d'échantillonnage H2, lorsque tous les interrupteurs K1, K'1, K"1 sont ouverts) ; ce potentiel, maintenu à sa valeur jusqu'au prochain créneau H1, peut être utilisé en vue d'une conversion analogique-numérique puisqu'il est proportionnel à Vm-Vr ; il représente directement la différence de signal due à l'impulsion lumineuse, indépendamment du niveau de lumière ambiante.

La figure 2 représente le diagramme de signaux correspondant au fonctionnement de la figure 1 :

- la ligne a représente les intervalles de temps périodiques d'émission d'impulsions lumineuses ;
- la ligne b représente le signal détecté par la cellule photosensible ; le niveau de signal dû à la lumière ambiante juste avant l'impulsion lumineuse est Ve=Vr ; le signal mesuré Vm à la fin de l'impulsion lumineuse représente l'addition de l'éclairement ambiant et de l'éclairement dû à l'impulsion lumineuse ;
- la ligne c représente le créneau de commande des interrupteurs K1 et K"1, correspondant à la phase d'initialisation H1 ; sa durée est par exemple la même que celle de l'impulsion lumineuse mais il commence à un instant T0 avant le début de l'impulsion lumineuse et se termine à un instant T1 juste avant la fin de l'impulsion lumineuse ;
- la ligne d représente le signal d'échantillonnage H2 qui commande l'interrupteur K'1 ; il commence juste après la fin du signal d'initialisation H1 et se termine à un instant T2 juste avant la fin de l'impulsion lumineuse ; sa durée est celle de l'impulsion lumineuse ;

- enfin, la ligne e représente l'opposé -Vs de la tension de sortie Vs, qui passe à zéro pendant le créneau H1 (initialisation) et qui prend la valeur Vm-Vr pendant le créneau H2 (échantillonnage) puis garde cette valeur jusqu'à la mesure suivante (blocage).

Cette méthode de double échantillonnage corrélé associé à une détection synchrone donne de très bons résultats.

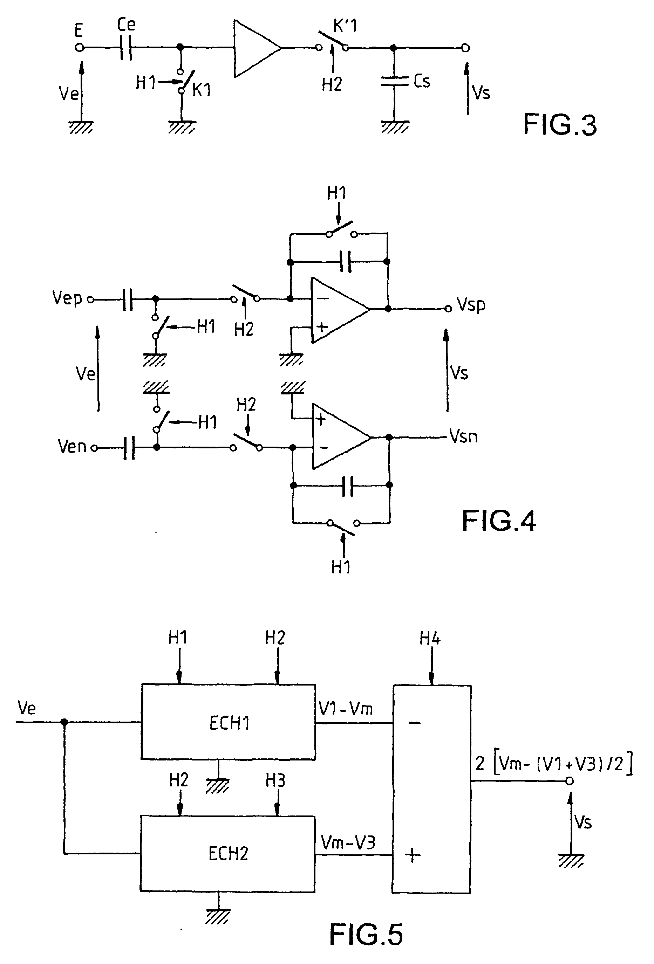

D'autres types d'échantillonneurs, plus simples ou plus complexes, existent et sont capables de faire l'opération de double échantillonnage corrélé. La figure 3 représente un échantillonneur particulièrement simple de l'art antérieur ; la figure 4 représente un échantillonneur bloqueur différentiel, accomplissant la même fonction de double échantillonnage corrélé, mais sur un signal utile différentiel Ve représentant la différence entre deux tensions Vep et Ven référencées par rapport à la masse.

L'invention part de l'observation que dans certaines applications cette méthode de mesure par détection synchrone et double échantillonnage corrélé n'est pas satisfaisante. Ces applications sont celles dans lesquelles le niveau de référence du signal mesuré (par exemple le niveau Vr représentant l'éclairement ambiant) n'est pas suffisamment stable. En effet, la méthode suppose que le niveau de référence n'a pas varié entre le début et la fin du signal H2.

Or la durée du signal H2 ne peut pas être diminuée au-dessous d'un minimum. Elle doit être au moins suffisante pour que le signal de mesure ait eu le temps de se stabiliser après le début de l'impulsion lumineuse. La durée de stabilisation est liée au temps de réponse de la cellule photosensible et de tous les circuits électroniques qui permettent d'établir la tension Ve à l'entrée de l'échantillonneur-bloqueur.

Typiquement, la durée de H2 peut être de 30 microsecondes. Mais si le niveau de référence Vr a le temps de varier de manière significative pendant cette durée, la mesure différentielle sera entachée d'une erreur puisqu'elle fait la différence entre le niveau Vm atteint à l'instant T2 au cours de l'impulsion et le niveau de référence V1 considéré à l'instant T1 avant le début de l'impulsion, au lieu de faire une différence à un même instant.

Dans une application particulièrement importante envisagée ici, on s'est aperçu que les variations de l'éclairement ambiant pendant la durée de l'impulsion brève de la mesure synchrone pouvaient aboutir à une erreur de mesure gênante, rendant l'application non fonctionnelle dans certains cas. Cette application est la détection de pluie sur un pare-brise de véhicule en vue de déclencher le balayage automatique par les essuie-glace. La détection est faite par une cellule photoélectrique (lumière visible ou infrarouge) qui détecte les changements de coefficient de réflexion du pare-brise selon la présence ou l'absence de pluie. Le changement de réflexion induit de faibles changements de niveau de signal de mesure, ces changements pouvant être mille fois plus faibles que le signal dû à l'éclairement ambiant. Mais l'éclairement ambiant subit des variations d'autant plus rapides que le véhicule va plus vite (passage sous des ponts, des arbres, etc.). Les variations en 30 microsecondes sont très significatives, et induisent des erreurs de mesure pouvant masquer les variations de coefficient de réflexion qu'on cherche à mesurer. La présence de pluie pourrait être détectée alors qu'il s'agit simplement d'une erreur de mesure.

C'est pourquoi l'invention propose une méthode et un dispositif de mesure avec détection synchrone par rapport à une impulsion de mesure, ce procédé et ce dispositif permettant de minimiser les erreurs de mesure dues aux variations de niveau de référence. Ce procédé et ce dispositif sont utilisables dans l'application qui vient d'être mentionnée mais aussi dans d'autres applications où des variations significatives et rapides du niveau de référence (niveau de signal engendré en l'absence de l'impulsion) pourraient advenir. Par "méthode de mesure avec détection synchrone", on entend une méthode de mesure dans laquelle, pour déterminer la valeur d'un paramètre à mesurer, on détecte la valeur d'un signal de mesure, en synchronisme avec une impulsion de mesure brève qui provoque une augmentation temporaire de ce signal. Ainsi, pour une mesure de coefficient de réflexion ou de transmission lumineuse dans un environnement ambiant lumineux, on émet une brève impulsion lumineuse et on mesure, pendant cette émission, le signal réfléchi ou transmis.

L'invention propose un procédé de mesure avec détection synchrone par rapport à une impulsion de mesure, dans lequel, pour déterminer la valeur d'un paramètre à mesurer, on émet une impulsion de mesure brève, on détecte , en synchronisme avec cette impulsion, la valeur Vm d'un signal de mesure qui possède un niveau de référence en l'absence de l'impulsion et un niveau augmenté en présence de l'impulsion, le niveau augmenté dépendant du paramètre à mesurer et le niveau de référence étant variable, le procédé comprenant un premier double échantillonnage corrélé entre un instant T1 situé juste avant le début de l'impulsion de mesure et un instant T2 situé juste avant la fin de l'impulsion de mesure, ce double échantillonnage fournissant une valeur du signal de mesure considérée à l'instant T2 par rapport à un niveau de référence V1 existant à l'instant T1 avant le début de l'impulsion, caractérisé en ce que, dans le but de compenser partiellement l'influence des variations, pendant la durée de l'impulsion, du niveau de référence du signal à mesurer, il comporte les étapes consistant:

- à effectuer un deuxième double échantillonnage corrélé entre l'instant T2 et un instant T3 situé après la fin de l'impulsion de mesure, ce deuxième échantillonnage fournissant une valeur du signal de mesure considérée à l'instant T2 par rapport à un niveau de référence V3 existant à l'instant T3 après la fin de l'impulsion,

- et à établir une différence entre des niveaux de signal issus des deux doubles échantillonnages, cette différence étant une représentation de la valeur de signal Vm considérée par rapport à un niveau de référence qui est intermédiaire entre les niveaux de référence aux instants T1 et T3.

L'intervalle de temps T3-T2 est de préférence sensiblement égal à T2-T1 ; la différence entre les niveaux de signal issus des deux mesures est alors une représentation de la valeur de signal Vm par rapport à la moyenne entre les niveaux de référence V1 et V3.

On comprendra que si les deux opérations de double échantillonnage corrélé sont effectuées de manière identique (sans changement de signe et de gain notamment) et si elles donnent respectivement des représentations de différences de niveaux Vm-V1 puis V3-Vm, la simple différence entre les deux résultats d'échantillonnage donnera un niveau de signal utile égal à 2[Vm-(V3+V1)/2] et non pas [Vm-(V3+1)/2] ; le signal véritablement recherché sera donc la moitié de la différence trouvée. Comme les signaux de sortie des échantillonneurs-bloqueurs sont en principe numérisés, la division par deux pourra, si elle est souhaitée car elle n'est pas forcément indispensable, être faite après numérisation. Cependant, des particularités de circuit analogiques peuvent aussi être utilisées si on le désire, sans changer le principe de l'invention, pour obtenir directement la valeur recherchée [Vm-(V3+V1)/2], par exemple une division capacitive, ou tout simplement un choix de capacité d'intégration deux fois plus forte que la capacité d'entrée, etc.

Le dispositif de mesure selon l'invention, avec détection synchrone par rapport à une impulsion de mesure qui provoque une augmentation temporaire d'un signal à mesurer, comporte au moins un échantillonneur bloqueur avec des moyens de commutation synchronisés avec l'impulsion de mesure pour effectuer à l'aide de l'échantillonneur bloqueur un premier double échantillonnage corrélé entre un instant T1 situé juste avant le début de l'impulsion de mesure et un instant T2 situé juste avant la fin de l'impulsion de mesure, ce double échantillonnage fournissant une mesure de signal Vm à l'instant T2 par rapport à un niveau de référence V1 à l'instant T1 avant le début de l'impulsion, caractérisé en ce que les moyens de commutation synchronisés avec l'impulsion de mesure sont adaptés à effectuer un deuxième double échantillonnage corrélé entre l'instant T2 et un instant T3 situé après la fin de l'impulsion de mesure (de préférence T3-T2=T2-T1), ce deuxième échantillonnage fournissant une représentation de la mesure de signal Vm à l'instant T2 par rapport à un niveau de référence V3 existant à l'instant T3 après la fin de l'impulsion, et en ce que le dispositif de mesure comporte des moyens pour établir une différence entre des niveaux de signal issus des deux mesures, cette différence étant une représentation de la valeur de signal Vm par rapport à un niveau de référence intermédiaire entre les niveaux de référence aux instants T1 et T3.

Dans une réalisation simple, on utilisera deux échantillonneurs bloqueurs établissant les niveaux de tension V1-Vm et Vm-V3 et on placera un soustracteur en sortie des échantillonneurs pour faire la différence recherchée.

Dans une autre réalisation, on utilisera un échantillonneur bloqueur différentiel, pour éviter que les signaux de mesure soient référencés par rapport à une masse. L'échantillonneur-bloqueur différentiel comportera selon l'invention un premier amplificateur opérationnel et un deuxième amplificateur opérationnel, chacun étant associé à une première et une deuxième capacité d'entrée placées en amont d'une entrée de l'amplificateur respectif, et étant associé également à une capacité d'intégration connectée entre l'entrée et la sortie de l'amplificateur, les entrées de signal de l'échantillonneur connectées aux premières capacités d'entrée étant croisées par rapport aux entrées de signal vers les deuxièmes capacités d'entrée ; les moyens de commutation comportent :

- des moyens pour faire fonctionner l'échantillonneur bloqueur en double échantillonneur bloqueur corrélé eu utilisant les capacités d'intégration et les premières capacités d'entrée, en appliquant initialement, à travers les premières capacités d'entrée, une tension d'entrée différentielle V1p-V1n représentant le signal de référence V1 à l'instant T1 et ultérieurement une tension d'entrée différentielle Vmp-Vmn représentant le signal de mesure Vm à l'instant T2 ;
- des moyens pour faire fonctionner l'échantillonneur bloqueur différentiel en double échantillonneur corrélé, en utilisant les capacités d'intégration et les deuxièmes capacités d'entrée, en appliquant initialement, à travers les deuxièmes capacités d'entrée, une tension d'entrée différentielle Vmn-Vmp représentant l'opposé -Vm du signal utile à l'instant T2 et ultérieurement une tension d'entrée différentielle V3n-V3p représentant l'opposé -V3 du signal de référence à l'instant T3.

L'échantillonneur bloqueur différentiel ainsi constitué fonctionne en triple échantillonneur corrélé avec un niveau de mesure de signal utile et deux niveaux de référence pris respectivement avant et après l'impulsion de mesure. Et il fait directement la différence Vm-(V3+V1)/2 en fournissant cette différence sous forme elle-même différentielle (donc non référencée par rapport à une masse). On notera que les amplificateurs opérationnels de l'échantillonneur-bloqueur différentiel peuvent ou non être pourvus d'un interrupteur de décharge périodique de la capacité d'intégration. Si c'est le cas, cet interrupteur est fermé pendant l'intervalle de temps de T1 à T2 pour assurer la remise à zéro de la charge de la capacité. Dans le cas contraire (pas de remise à zéro de la capacité d'intégration par un court-circuit), un autre moyen est prévu pour ramener périodiquement sur la capacité d'intégration une charge représentant l'opposé de la valeur moyenne du signal de sortie utile. Cette dernière solution sera utilisée notamment lorsque le signal de sortie utile est de toutes façons destiné à être filtré par un filtre passe-bas avant d'être exploité, car alors on dispose de cette valeur moyenne (sortie du filtre).

Les deux amplificateurs opérationnels peuvent être remplacés par un amplificateur différentiel unique avec deux entrées différentielles et deux sorties différentielles. Dans ce cas, la structure du circuit peut être reformulée de la manière suivante : l'échantillonneur-bloqueur différentiel comporte un amplificateur différentiel à deux entrées et deux sorties, chaque entrée étant associée à une première et une deuxième capacité d'entrée placées en amont de cette entrée, et étant associée également à une capacité d'intégration connectée entre l'entrée et une sortie correspondante de l'amplificateur, les entrées de signal de l'échantillonneur connectées aux premières capacités d'entrée étant croisées par rapport aux entrées de signal connectées aux deuxièmes capacités d'entrée ; les moyens de commutation comportent :

- des moyens pour faire fonctionner l'échantillonneur bloqueur en double échantillonneur bloqueur corrélé en utilisant les capacités d'intégration et les premières capacités d'entrée, en appliquant initialement, à travers les premières capacités d'entrée, une tension d'entrée différentielle V1p-V1n représentant le signal de référence V1 à l'instant T1 et ultérieurement une tension d'entrée différentielle Vmp-Vmn représentant le signal de mesure Vm à l'instant T2 ;
- des moyens pour faire fonctionner l'échantillonneur bloqueur différentiel en double échantillonneur corrélé, en utilisant les capacités d'intégration et les deuxièmes capacités d'entrée, en appliquant initialement, à travers les deuxièmes capacités d'entrée, une tension d'entrée différentielle Vmn-Vmp représentant l'opposé -Vm du signal utile à l'instant T2 et ultérieurement une tension d'entrée différentielle V3n-V3p représentant l'opposé -V3 du signal de référence à l'instant T3.

Cette définition doit être considérée comme équivalente de la définition utilisant deux amplificateurs opérationnels distincts.

On notera que le brevet US 4 262 258 décrit un système de lecture par quadruple échantillonnage corrélé pour multiplier par deux le niveau de tension issu d'un dispositif à couplage de charges (CCD) sans multiplier par deux le bruit de lecture.

D'autres caractéristiques et avantages de l'invention apparaîtront à la lecture de la description détaillée qui suit et qui est faite en référence aux dessins annexés dans lesquels :

- les figures 1 à 4, déjà décrites, représentent une mesure classique de signal utile en présence d'une référence inconnue, par détection synchrone et double échantillonnage corrélé ;
- la figure 5 représente un schéma de principe de l'invention ;
- la figure 6 représente un chronogramme correspondant à la figure 5 ;
- la figure 7 représente une réalisation différentielle de l'invention, avec deux amplificateurs opérationnels communs à deux échantillonneurs bloqueurs ;
- la figure 8 représente une autre réalisation différentielle, sans interrupteurs de remise à zéro des capacités d'intégration ;
- la figure 9 représente une application de l'invention à la détection de pluie sur un pare-brise.

Sur la figure 5, on voit deux échantillonneurs bloqueurs ECH1 et ECH2 recevant un même signal d'entrée Ve. Le signal d'entrée est un signal résultant d'une mesure en détection synchrone, c'est-à-dire comme expliqué ci-dessus un signal qui résulte d'une impulsion de mesure permettant de superposer un signal de mesure utile à un niveau de référence inconnu. Les deux échantillonneurs bloqueurs fonctionnent en double échantillonnage corrélé, mais pendant des intervalles de temps différents.

Le premier échantillonneur ECH1 fonctionne avec une phase d'initialisation H1 commençant à un instant T0 et se terminant à un instant T1 situé juste avant le début de l'impulsion de mesure, avec une phase d'échantillonnage H2 commençant à l'instant T1 et se terminant à un instant T2 situé juste avant la fin de l'impulsion de mesure, et avec une phase de blocage qui suit la phase d'échantillonnage. Ce premier échantillonneur fournit une tension de sortie Vs proportionnelle à -(Vm-V1), où V1 est la valeur de Ve à l'instant T1 (valeur de référence avant l'impulsion), et Vm est la valeur de Ve à l'instant T2 (valeur de mesure pendant l'impulsion). La durée T1-T0 est de préférence la même que la durée de l'impulsion de mesure. La durée T2-T1 aussi.

Le deuxième échantillonneur ECH2 fonctionne avec une phase d'initialisation qui se termine juste avant la fin de l'impulsion de mesure, une phase d'échantillonnage qui commence à la fin de la phase d'initialisation et qui se termine à un instant T3 situé après la fin de l'impulsion de mesure. De préférence, la phase d'initialisation coïncide avec la phase H2 (début à T1, fin à T2) ; la phase d'échantillonnage H3 commence à l'instant T2 et se termine à un instant T3 qui est de préférence tel que la durée de la phase H3 soit la même que celle de la phase H2. La fin de la phase d'échantillonnage H3 est suivie par une phase de blocage. Cette phase de blocage comporte au moins une durée simultanée avec la phase de blocage du premier échantillonneur. La partie commune s'étend de l'instant T3 jusqu'à la prochaine phase d'initialisation (instant T'0). Le deuxième échantillonneur fournit pendant cette phase une tension proportionnelle à Vm-V3, où V3 est la valeur de Ve à l'instant T3, c'est-à-dire la valeur de référence après l'impulsion de mesure.

Un soustracteur reçoit les sorties des deux échantillonneurs et permet d'obtenir, pendant un intervalle de temps qui peut être défini par un créneau H4 s'étendant de T3 à T'0 ou situé à l'intérieur de cet intervalle, la différence entre les niveaux de tension bloqués obtenus après l'instant T3 en sortie des deux échantillonneurs.

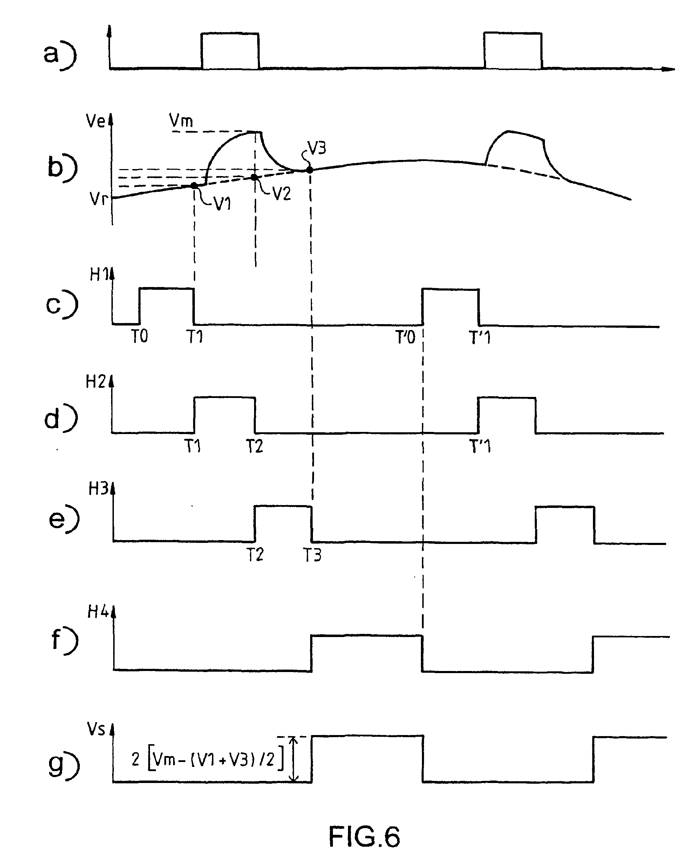

La figure 6 représente un diagramme de signaux de fonctionnement du circuit de mesure de la figure 5.

- ligne a : impulsions de mesure périodiques en vue d'une détection synchrone ;
- ligne b : signal Ve détecté par le circuit de mesure ; le niveau de signal de référence en l'absence d'impulsion est Vr , mais Vr varie au cours du temps ; Vr est égal à V1 juste avant l'impulsion de mesure, à V2 à l'instant T2, à V3 à l'instant T3, mais on ne connaît pas précisément son niveau à ces instants ; à l'instant T2 cependant, le signal d'entrée Ve détecté est Vm, représentant l'addition du niveau de référence V2 et du niveau utile dû à l'impulsion de mesure ;
- ligne c : créneau correspondant à la phase d'initialisation H1 du premier échantillonneur ; sa durée est de préférence la même que celle de l'impulsion de mesure ; il se termine à un instant T1 juste avant le début de l'impulsion de mesure ; il commence à un instant T0 tel que T1-T0 soit de préférence égal à la durée de l'impulsion de mesure ;
- ligne d : le signal d'échantillonnage H2 ; il commence juste après la fin du signal d'initialisation H1 et se termine à un instant T2 juste avant la fin de l'impulsion de mesure ; sa durée est celle de l'impulsion de mesure ; c'est aussi le signal d'initialisation du deuxième échantillonneur;
- ligne e : le signal d'échantillonnage H3 du deuxième échantillonneur ; il dure de T2 à T3 ; la durée T3-T2 est de préférence égale à T2-T1 et T1-T0 ;
- ligne f : un créneau H4 (facultatif) permettant d'activer le soustracteur seulement pendant la phase de blocage commune des deux échantillonneurs, c'est-à-dire après le temps T3 et avant la mesure suivante ;
- ligne g : la sortie Vs du soustracteur, qui a une valeur proportionnelle à [Vm-(V3+V1)/2] pendant l'intervalle de temps H4 et qui peut ou non être nulle ou égale à une valeur précédente en dehors de ces intervalles.

La valeur Vs est alors (au coefficient 2 ou -2 près) très proche d'une valeur théorique recherchée qui serait Vm-V2, dès lors que (V1+V3)/2 peut être considéré comme très proche de V2, ce qui est en général le cas lorsque T3-T2 est égal à T2-T1. Ceci suppose que l'évolution de Vr peut être considérée comme à peu près linéaire sur la durée T1, T3, et cette supposition est acceptable dans beaucoup d'applications.

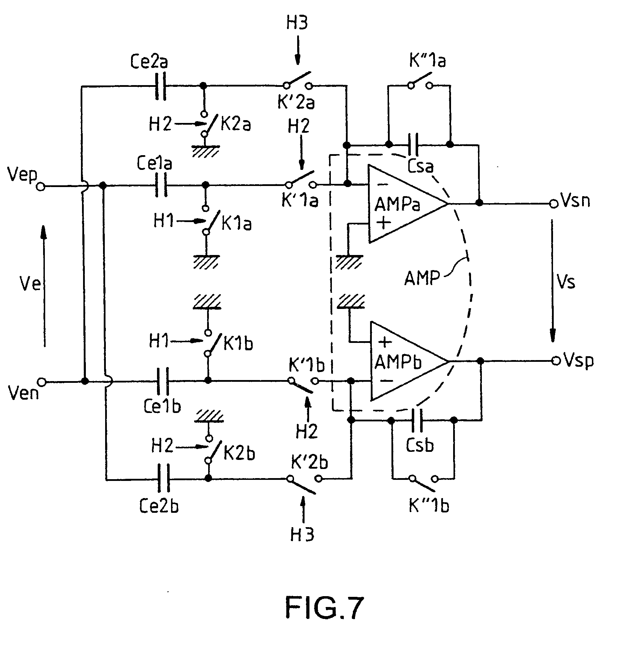

La figure 7 représente une réalisation pratique dans laquelle l'échantillonneur bloqueur utilisé est un échantillonneur bloqueur différentiel inspiré de celui de la figure 4 ; dans ce cas, il n'est pas nécessaire de prévoir, pour mettre en oeuvre la présente invention, deux échantillonneurs différentiels et un soustracteur. On peut en effet réaliser la même fonction de triple échantillonnage corrélé avec une seule paire d'amplificateurs opérationnels ou (de manière équivalente) un amplificateur différentiel à deux entrées différentielles et deux sorties différentielles, en ajoutant seulement d'autres capacités commutées. Le schéma de la figure 7 part donc du schéma de la figure 4 ou d'un autre schéma d'échantillonneur différentiel qui possède deux amplificateurs opérationnels AMPa AMPb avec pour chacun une capacité d'entrée Ce1a et Ce1b et une capacité d'intégration Csa et Csb, et les commutateurs qui permettent le fonctionnement en double échantillonnage corrélé ; et on rajoute à ce schéma un couple de deuxièmes capacités d'entrée commutées Ce2a et Ce2b. Sur le couple de premières capacités d'entrée Ce1a et Ce1b on applique la tension différentielle d'entrée Ve représentant le signal à mesurer. Sur le couple de deuxièmes capacités d'entrée Ce2a et Ce2b on applique l'opposé -Ve de cette tension Ve, ce qui veut dire qu'on croise les connexions de l'entrée vers les deux capacités.

Plus précisément, la tension différentielle d'entrée Ve à mesurer est constituée à partir de deux tensions Vep et Ven référencées par rapport à la masse électrique du circuit. La tension Vep est appliquée à la première capacité d'entrée Ce1a associée au premier amplificateur opérationnel AMPa et elle est appliquée aussi à la deuxième capacité d'entrée Ce2b associée au deuxième amplificateur opérationnel AMPb ; de même, la tension Ven est appliquée à la première capacité d'entrée Ce1b du deuxième amplificateur AMPb et à la deuxième capacité d'entrée Ce2a du premier amplificateur AMPa.

Les capacités d'intégration sont connectées chacune en parallèle entre la sortie et l'entrée inverseuse de l'amplificateur auquel elles sont associées respectivement (Csa pour AMPa et Csb pour AMPb). L'entrée non-inverseuse des amplificateurs est à la masse. La sortie Vsp est la sortie de l'amplificateur AMPb, la sortie Vsn est celle de l'amplificateur AMPa ; la tension de sortie différentielle est Vs = Vsp-Vsn.

Sur la figure 7 on a représenté en traits tiretés un cadre AMP représentant un amplificateur différentiel unique, montrant qu'il y a équivalence entre l'utilisation de deux amplificateurs simples ou un amplificateur différentiel.

Les capacités d'entrée sont toutes égales. Les capacités d'intégration sont égales entre elles et sont dans un rapport de proportionnalité k avec les capacités d'entrée, k dépendant du niveau de tension qu'on veut obtenir en sortie ;

si k=2, la tension différentielle de sortie Vs=Vsp-Vsn entre les sorties des amplificateurs pendant la phase de blocage où tous les interrupteurs sont ouverts est égale à [Ve-(V3+V1)/2] où V3 et V1 ont les mêmes significations que précédemment, à savoir les valeurs de tension de référence (différentielles) au temps T1 avant l'impulsion de mesure et au temps T3 après l'impulsion de mesure. Si k est différent de 2, la tension de sortie est divisée par k/2.

Les chronogrammes de signaux de commande d'interrupteurs sont les mêmes qu'à la figure 6, à l'exception du signal H4 qui n'est pas nécessaire dans la réalisation de la figure 7.

Pour effectuer le triple échantillonnage corrélé désiré, sous forme d'un double échantillonnage entre les instants T0 et T2 suivi d'un double échantillonnage entre les instants T1 et T3 comme expliqué en référence aux figures 5 et 6, on prévoit dans le schéma de la figure 7 :

- des interrupteurs K1a et K1b reliés entre une capacité d'entrée Ce1a ou Ce1b respectivement et la masse, fermés pendant les créneaux d'initialisation H1 (de T0 à T1) de la première opération de double échantillonnage, pour pouvoir charger la capacité Ce1a par une tension V1 p (signal d'entrée Vep à l'instant T1) et la capacité Ce1b par une tension V1 n (signal d'entrée Ven à l'instant T1) ;
- des interrupteurs K'1a et K'1b reliés entre les capacités Ce1a ou Ce1b respectivement et l'entrée inverseuse de l'amplificateur associé (AMPa, AMPb respectivement) ; ces interrupteurs sont fermés pendant le créneau H2 (entre T1 et T2) pour relier la capacité Ce1a entre l'entrée Vep et l'amplificateur AMPa, ainsi que la capacité Ce1b entre l'entrée Ven et l'amplificateur AMPb, pendant cet intervalle de temps T1,T2 ;
- des interrupteurs K"1a et K"1b en parallèle respectivement sur la capacité d'intégration Csa et la capacité d'intégration Csb ;
- des interrupteurs K2a et K2b montés vis-à vis des capacités Ce2a et Ce2b respectivement comme les interrupteurs K1 a et K1 b sont montés vis-à-vis des capacités Ce1a et Ce1b respectivement ; on rappelle que la capacité Ce1a reçoit la tension Vep et la capacité Ce1b reçoit la tension Ven ; inversement c'est la capacité Ce2b qui reçoit Vep et la capacité Ce2aqui reçoit Ven ; les interrupteurs K2a et K2b sont fermés pendant la phase H2 qui est une phase d'échantillonnage pour la première opération de double échantillonnage et une phase d'initialisation pour la deuxième opération de double échantillonnage ;
- des interrupteurs K2'a et K2'b montés vis-à-vis des amplificateurs AMPa et AMPb respectivement et vis-à-vis des capacités Ce2aet Ce2b respectivement comme les interrupteurs K'1a et K'1b respectivement ; les interrupteurs K'2a et K'2b sont fermés pendant la phase H3 qui est une phase d'échantillonnage de la deuxième opération de corrélation.

Les interrupteurs sont tous ouverts pendant la phase de blocage qui suit la phase H3 et qui dure jusqu'à la prochaine étape de mesure débutant au temps T'0.

Pendant la première opération de double échantillonnage corrélé, de T0 à T2, la phase d'initialisation (H1) remet à zéro la charge des capacités d'intégration Csa et Csb et place sur Ce1a et Ce1b les tensions d'entrée Vep et Ven respectivement qui sont alors égales à une référence de niveau V1p et V1 n respectivement avec un niveau différentiel initial V1=V1p-V1 n. Les valeurs V1 p, V1n, et leur différence V1 représentent les niveaux de tension de référence avant l'impulsion de mesure. Puis la phase d'échantillonnage répartit, à T2, entre Ce1a et Csa, la charge ainsi initialisée sur Ce1a, en même temps que la tension de mesure Vep, résultant du signal utile à mesurer, est appliquée à l'entrée de Ce1a ; il s'établit en sortie de l'amplificateur AMPa une tension de sortie Vsn = -(Vep-V1 p)/2 en supposant que les capacités d'intégration soient deux fois plus fortes que les capacités d'entrée.

De même il s'établit en sortie AMPb une tension Vsp = -(Ven-V1n)/2

En même temps (instant T2), des charges initiales sont stockées dans les capacités Ce2a et Ce2b puisque la phase H2 est la phase d'initialisation de la deuxième opération de double échantillonnage corrélé. Ces charges sont :

- sur Ce2a : une charge correspondant à la tension Ven
- sur Ce2b : une charge correspondant à la tension Vep.

Au cours de la phase H3, phase d'échantillonnage de la deuxième opération de double échantillonnage corrélé, la charge de Ce2a se répartit entre la capacité Ce2a et la capacité Csa ; la charge de la capacité Ce2b se répartit entre la capacité Ce2b et la capacité Csb. En même temps, à l'instant T3, la tension appliquée sur la borne d'entrée de Ce2a est Ven=V3n et la tension appliquée à l'entrée de Ce2b est Vep=V3p.

V3n et V3p sont les tensions d'entrée à l'instant T3 et correspondent au niveau de référence en dehors de l'impulsion de mesure après cette impulsion. V3=V3p-V3n est la tension de référence différentielle à cet instant T3.

Il en résulte sur la sortie de l'amplificateur AMPa une tension

$$Vsn = -(Vep-V1p)/2 - (V3n-Ven)/2$$

Et sur la sortie de l'amplificateur AMPb une tension

$$Vsp = -(Ven-V1n)/2 - (V3p-Vep)/2$$

La tension différentielle de sortie entre les sorties de AMPb et AMPa est alors

$$Vs = Vsp-Vsn = (Vep-Ven) - (V1p-V1n)/2 -(V3p-V3n)/2$$

Ou encore

$$Vs = Ve - (V1+V3)/2$$

On a donc bien une mesure du signal utile Ve par rapport à un niveau de référence (V1+V3)/2 intermédiaire entre V1 (référence avant l'impulsion de mesure) et V3 (référence après l'impulsion), Ce niveau de référence intermédiaire est la moyenne entre V1 et V3 et représente une très bonne approximation du niveau de référence probable existant à l'instant T2 où ce niveau n'est pas mesurable, dès lors que la variation du niveau de référence peut être considérée comme linéaire et dès lors que T2 est équidistant de T1 et T3.

Dans le schéma de la figure 7, on prévoit des interrupteurs K"1a et K"1b pour remettre périodiquement à zéro la charge des capacités d'intégration Csa et Csb avant une phase d'échantillonnage H2. Mais ces interrupteurs sont facultatifs : on peut prévoir en effet un autre moyen d'initialisation de l'échantillonneur bloqueur. Ce moyen consiste à réinjecter périodiquement sur l'entrée négative de chaque amplificateur opérationnel, à l'aide de capacités commutées, une tension égale à l'opposé de la valeur moyenne du signal de sortie de l'échantillonneur différentiel.

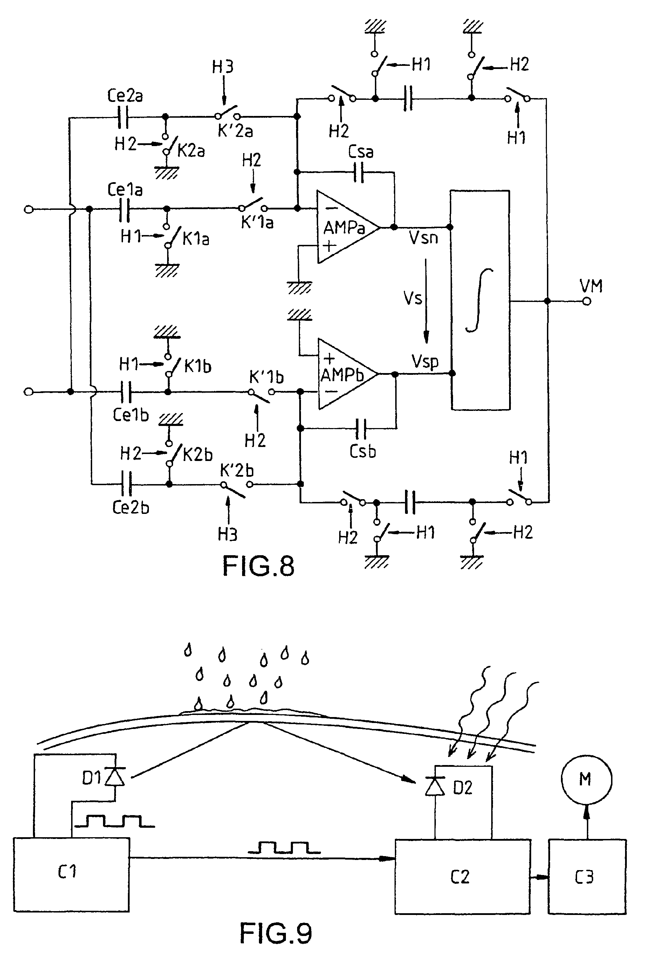

Dans ce cas, on dispose en sortie des amplificateurs opérationnels, comme le montre la figure 8, un filtre intégrateur FL qui reçoit la sortie différentielle de l'échantillonneur bloqueur et qui établit une valeur moyenne de cette sortie. Cette valeur moyenne VM est réinjectée sur l'entrée inverseuse de l'amplificateur AMPa et sur celle de l'amplificateur AMPb, grâce à des systèmes de capacités commutées pendant des phases H1 et H2.

L'avantage de cette solution se présente dans les cas où on a besoin de toutes façons de filtrer la mesure faite en détection synchrone pour mesurer la moyenne du signal détecté. Dans ce cas on dispose du filtre intégrateur de toutes façons et il est donc préférable de l'utiliser plutôt que de prévoir les interrupteurs K"1 a et K"1 b.

La figure 9 représente un exemple d'application où l'invention est particulièrement intéressante. Il s'agit de la détection de pluie sur un pare-brise PB de véhicule, en vue de déclencher le mouvement d'un essuie-glace. Une cellule photoélectrique est utilisée, comportant par exemple une diode électroluminescente D1 et une photodiode D2.

Une diode électroluminescente D1 émet périodiquement des impulsions lumineuses sous la commande d'un circuit C1. Une photodiode de détection D2 reçoit ces impulsions après réflexion sur le pare-brise mais elle reçoit aussi la lumière ambiante. Le coefficient de réflexion du pare-brise dépend du fait que ce dernier reçoit ou non de la pluie. Le signal fourni par la photodiode D2 à un circuit de mesure C2 est une mesure de l'éclairement ambiant, mais il augmente pendant les impulsions lumineuses puisqu'il correspond alors à l'addition de l'éclairement ambiant et de l'éclairement supplémentaire fourni par la réflexion sur le pare-brise de l'émission de la diode électroluminescente D1.

Le circuit C2 est un circuit selon l'invention tel que décrit ci-dessus. Le circuit C1 (ou un autre circuit de séquencement) fournit les signaux de commande H1, H2, H3 du circuit C2 conformément aux diagrammes expliqués ci-dessus, pour que le circuit C2 fonctionne en synchronisme avec le circuit C1.

Le circuit C2 fournit une valeur utile de signal, éventuellement filtrée, qui est fournie à un circuit de décision C3. Le circuit de décision évalue la valeur des signaux et les compare avec un ou plusieurs seuils pour déterminer la présence ou l'absence de pluie et commander l'actionnement d'un moteur M d'entraînement d'essuie-glace en cas de détection de pluie.

**Revendications**

1. Procédé de mesure avec détection synchrone par rapport à une impulsion de mesure, dans lequel, pour déterminer la valeur d'un paramètre à mesurer, on émet une impulsion de mesure brève, on détecte , en synchronisme avec cette impulsion, la valeur Vm d'un signal de mesure qui possède un niveau de référence en l'absence de l'impulsion et un niveau augmenté en présence de l'impulsion, le niveau augmenté dépendant du paramètre à mesurer et le niveau de référence étant variable, le procédé comprenant un premier double échantillonnage corrélé entre un instant T1 situé juste avant le début de l'impulsion de mesure et un instant T2 situé juste avant la fin de l'impulsion de mesure, ce double échantillonnage fournissant une valeur du signal de mesure considérée à l'instant T2 par rapport à un niveau de référence V1 existant à l'instant T1 avant le début de l'impulsion, **caractérisé en ce que**, dans le but de compenser partiellement l'influence des variations, pendant la durée de l'impulsion, du niveau de référence du signal à mesurer, il comporte les étapes consistant:

- à effectuer un deuxième double échantillonnage corrélé entre l'instant T2 et un instant T3 situé après la fin de l'impulsion de mesure, ce deuxième échantillonnage fournissant une valeur du signal de mesure considérée à l'instant T2 par rapport à un niveau de référence V3 existant à l'instant T3 après la fin de l'impulsion,
- et à établir une différence entre des niveaux de signal issus des deux doubles échantillonnages, cette différence étant une représentation de la valeur de signal Vm considérée par rapport à un niveau de référence qui est intermédiaire entre les niveaux de référence aux instants T1 et T3.

2. Procédé de mesure selon la revendication 1, **caractérisé en ce que** l'intervalle de temps T3-T2 est sensiblement égal à T2-T1.

3. Procédé de mesure selon l'une des revendications 1 et 2, **caractérisé en ce que** l'intervalle de temps T3-T2 est sensiblement égal à la durée de l'impulsion de mesure.

4. Procédé de mesure selon l'une des revendications 1 et 2, **caractérisé en ce que** l'intervalle de temps T2-T1 est sensiblement égal à la durée de l'impulsion de mesure.

5. Procédé de mesure selon l'une des revendications 1 à 4, **caractérisé en ce que** l'impulsion de mesure est une impulsion de lumière, et le signal de mesure est détecté au moyen d'une cellule photosensible.

6. Procédé de mesure selon l'une des revendications 1 à 5, **caractérisé en ce qu'**il est appliqué à la détection de pluie sur un pare-brise de véhicule, l'impulsion de mesure étant une impulsion lumineuse émise vers le pare-brise et réfléchie avec un coefficient de réflexion qui dépend de la présence ou l'absence de pluie sur le pare-brise.

7. Dispositif de mesure avec détection synchrone par rapport à une impulsion de mesure qui provoque une augmentation temporaire d'un signal à mesurer, comportant au moins un échantillonneur bloqueur, avec des moyens de commutation (K1 a, K'1a, K1 b, K'1b, K2a, K'2a, K2b, K'2b) synchronisés avec l'impulsion de mesure pour effectuer à l'aide de l'échantillonneur bloqueur un premier double échantillonnage corrélé entre un instant T1 situé juste avant le début de l'impulsion de mesure et un instant T2 situé juste avant la fin de l'impulsion de mesure, ce double échantillonnage fournissant une mesure de signal Vm à l'instant T2 par rapport à un niveau de référence V1 à l'instant T1 avant le début de l'impulsion, **caractérisé en ce que** les moyens de commutation synchronisés avec l'impulsion de mesure sont adaptés à effectuer un deuxième double échantillonnage corrélé entre l'instant T2 et un instant T3 situé après la fin de l'impulsion de mesure, ce deuxième échantillonnage fournissant une représentation de la mesure de signal Vm à l'instant T2 par rapport à un niveau de référence V3 existant à l'instant T3 après la fin de l'impulsion, et **en ce que** dispositif de mesure comporte des moyens pour établir une différence entre des niveaux de signal issus des deux mesures, cette différence étant une représentation de la valeur de signal Vm par rapport à un niveau de référence intermédiaire entre les niveaux de référence aux instants T1 et T3.

8. Dispositif selon la revendication 7, **caractérisé en ce qu'**il comporte deux échantillonneurs bloqueurs (ECH1, ECH2) établissant les niveaux de tension V1-Vm et Vm-V3 et un soustracteur en sortie des échantillonneurs pour faire la différence recherchée.

9. Dispositif selon la revendication 7, **caractérisé en ce que** l'échantillonneur-bloqueur est différentiel et comporte deux entrées de signal et un amplificateur différentiel (AMPa, AMPb), ayant deux entrées et deux sorties, chaque entrée de l'amplificateur étant associée à une première et une deuxième capacité d'entrée (Cea1, Cea2 ; Ceb1, Ceb2) placées en amont de cette entrée, et étant associée également à une capacité d'intégration (Csa, Csb) connectée entre l'entrée et une sortie correspondante de l'amplificateur, les entrées de signal de l'échantillonneur connectées aux premières capacités d'entrée étant croisées par rapport aux entrées de signal connectées aux deuxièmes capacités d'entrée ; les moyens de commutation comportant :

- des commutateurs (K1a, K'1a, K1b, K'1b) pour faire fonctionner l'échantillonneur bloqueur en double échantillonneur bloqueur corrélé en utilisant les capacités d'intégration et les premières capacités d'entrée, en appliquant initialement, à travers les premières capacités d'entrée, une tension d'entrée différentielle V1p-V1n représentant le signal de référence V1 à l'instant T1 et en appliquant ultérieurement une tension d'entrée différentielle Vmp-Vmn représentant le signal de mesure Vm à l'instant 12 ;
- des commutateurs (K2a, K'2a, K2b, K'2b) pour faire fonctionner l'échantillonneur bloqueur différentiel en double échantillonneur corrélé, en utilisant les capacités d'intégration et les deuxièmes capacités d'entrée, en appliquant initialement, à travers les deuxièmes capacités d'entrée, une tension d'entrée différentielle Vmn-Vmp représentant l'opposé -Vm du signal de mesure à l'instant T2 et en appliquant ultérieurement une tension d'entrée différentielle V3n-V3p représentant l'opposé -V3 du signal de référence à l'instant T3.

**10.** Dispositif selon la revendication 9, **caractérisé en ce que** les amplificateurs opérationnels sont pourvus d'un interrupteur (K"1a, K"1b) de décharge périodique de la capacité d'intégration.

**11.** Dispositif selon la revendication 10, **caractérisé en ce qu'**il est prévu un moyen (FL) pour ramener périodiquement sur une entrée de chaque amplificateur opérationnel une tension représentant l'opposé de la valeur moyenne du signal de sortie de l'échantillonneur différentiel.

**12.** Dispositif selon l'une des revendications 7 à 11, **caractérisé en ce qu'**il comporte une cellule photoémissive pour émettre une impulsion lumineuse constituant l'impulsion de mesure et une cellule photosensible pour fournir le signal à mesurer.

**Claims**

**1.** A process for measuring with synchronous detection in relation to a measuring pulse wherein, in order to determine the value of a parameter to be measured, a short measuring pulse is emitted and, in synchronism with this pulse, the value Vm of a measuring signal is detected which has a reference level in the absence of the pulse and an increased level in the presence of the pulse, the increased level depending on the parameter to be measured and the reference level being variable; the process comprising a first correlated double sampling between an instant T1 situated just before the start of the measuring pulse and an instant T2 situated just before the end of the measuring pulse, this double sampling supplying a measuring signal value considered at instant T2 in relation to a reference level V1 existing at instant T1 before the start of the pulse, **characterised in that** in order to partially compensate the influence of variations of the reference level of the signal to be measured throughout the duration of the pulse, it includes the following steps:

- performing a second double correlated sampling between instant T2 and an instant T3 situated after the end of the measuring pulse, this second sampling supplying a measuring signal value considered at instant T2 in relation to a reference level V3 existing at instant T3 after the end of the pulse,
- and establishing a difference between the signal levels originating from the two double samplings, which difference being a representation of signal value Vm considered in relation to an intermediate reference level between the reference levels at instants T1 and T3.

**2.** The process for measuring according to claim 1, **characterised in that** the T3-T2 time interval is essentially equal to T2-T1.

**3.** The process for measuring according to any one of claims 1 and 2, **characterised in that** the T3-T2 time interval is essentially equal to the duration of the measuring pulse.

**4.** The process for measuring according to any one of claims 1 and 2, **characterised in that** the T2-T1 time interval is essentially equal to the duration of the measuring pulse.

**5.** The process for measuring according to any one of claims 1 to 4, **characterised in that** the measuring pulse is a light pulse and the measuring signal is detected by means of a photosensitive cell.

**6.** The process for measuring according to any one of claims 1 to 5, **characterised in that** it is applied to rain detection on a vehicle windscreen, the measuring pulse being a light pulse emitted towards the windscreen and reflected with a reflection coefficient depending on the presence or absence of rain on the windscreen.

7. A measuring device with synchronous detection in relation to a measuring pulse which causes a temporary increase in a signal to be measured, comprising at least one sample-and-hold circuit, with commutation means (K1a, K'1a, K1b, K'1b, K2a, K'2a, K2b, K'2b) synchronised with the measuring pulse, in order to perform, by means of the sample-and-hold circuit, a first correlated double sampling between an instant T1 situated just before the start of the measuring pulse and an instant T2 situated just before the end of the measuring pulse, this double sampling supplying a measuring signal Vm at instant T2 in relation to a reference level V1 at instant T1 before the start of the pulse, **characterised in that** the commutation means synchronised with the measuring pulse are adapted to realise a second correlated double sampling between instant T2 and an instant T3 situated after the end of the measuring pulse, this second sampling supplying a representation of the signal measurement Vm at instant T2 in relation to a reference level V3 existing at instant T3 after the end of the pulse, and **in that** the measuring device comprises means for establishing a difference between the signal levels originating from both measurements, this difference being a representation of the signal value Vm in relation to an intermediate reference level between the reference levels at instants T1 and T3.

8. Device according to claim 7, **characterised in that** it comprises two sample-and-hold circuit (ECH1, ECH2) establishing voltage levels V1-Vm and Vm-V3 and a subtractor at the output of the samplers to obtain the desired difference.

9. Device according to claim 7, **characterised in that** the sample-and-hold circuit is differential and comprises two signal inputs and a differential amplifier (AMPa, AMPb) having two inputs and two outputs, each amplifier input being associated with a first and a second input capacitor (Cea1, Cea2; Ceb1, Ced2) placed upstream of this input, and being equally associated with an integrating capacitor (Csa, Csb) connected between the input and a corresponding amplifier output, the signal inputs of the sampler connected to the first input capacitors being crossed in relation to the signal inputs connected to the second input capacitors; the commutation means comprising:

- switches (K1a, K'1a, K1b, K'1b) for operating the sample-and-hold circuit as a correlated double sample-and-hold circuit using the integrating capacitors and the first input capacitors, by initially applying, through the first input capacitors, a differential input voltage V1p-V1n representing the reference signal V1 at instant T1 and subsequently applying a differential input voltage Vmp-Vmn representing the measuring signal Vm at instant T2.
- switches (K2a, K'2a, K2b, K'2b) for operating the sample-and-hold circuit as a correlated double sample-and-hold circuit using the integrating capacitors and the second input capacitors, by initially applying, through the second input capacitors, a differential input voltage Vmn-Vmp representing the opposite -Vm of the measuring signal at instant T2 and subsequently applying a differential input voltage V3n-V3p representing the opposite -V3 of the reference measuring signal at instant T3.

10. Device according to claim 9, **characterised in that** the operational amplifiers are equipped with a switch (K"1a, K"1b) for periodic discharging of the integrating capacitor.

11. Device according to claim 10, **characterised in that** a means (FL) is provided for periodically applying a voltage representing the inverse of the mean value of the differential sampler output signal to one input on each operational amplifier.

12. Device according to any one of claims 7 to 11, **characterised in that** it comprises a photoemissive cell for emitting a light pulse constituting the measuring pulse and a photosensitive cell for supplying the signal to be measured.

**Patentansprüche**

1. Messverfahren mit synchroner Detektion in Bezug auf einen Messimpuls, wobei zum Ermitteln des Wertes eines zu messenden Parameters ein kurzer Messimpuls emittiert und synchron zu diesem Impuls der Wert Vm eines Messsignals detektiert wird, das einen Referenzpegel in Abwesenheit des Impulses und einen erhöhten Pegel in Anwesenheit des Impulses hat, wobei der erhöhte Pegel von dem zu messenden Parameter abhängt und der Referenzpegel variabel ist; wobei das Verfahren eine erste korrelierte Doppelabtastung zwischen einem unmittelbar vor dem Start des Messimpulses vorliegenden Zeitpunkt T1 und einem unmittelbar vor dem Ende des Messimpulses vorliegenden Zeitpunkt T2 beinhaltet, wobei diese Doppelabtastung einen Messsignalwert ergibt, der zum Zeitpunkt T2 in Bezug auf einen Referenzpegel V1 berücksichtigt wird, der zum Zeitpunkt T1 vor dem Start des Impulses vorliegt, **dadurch gekennzeichnet, dass** es zum teilweisen Kompensieren des Einflusses von Variationen des Referenzpegels des zu messenden Signals während der Dauer des Impulses die folgenden Schritte beinhaltet:

- Ausführen einer zweiten korrelierten Doppelabtastung zwischen dem Zeitpunkt T2 und einem Zeitpunkt T3, der hinter dem Ende des Messimpulses liegt, wobei diese zweite Abtastung einen Messsignalwert ergibt, der zum Zeitpunkt T2 in Bezug auf einen Referenzpegel V3 berücksichtigt wird, der zum Zeitpunkt T3 nach dem Ende des Impulses vorliegt, und

- Feststellen einer Differenz zwischen den von den beiden Doppelabtastungen stammenden Signalpegeln, wobei diese Differenz eine Repräsentation des Signalwertes Vm ist, die in Bezug auf einen Zwischenreferenzpegel zwischen den Referenzpegeln zu den Zeitpunkten T1 und T3 berücksichtigt wird.

2. Messverfahren nach Anspruch 1, **dadurch gekennzeichnet, dass** das Zeitintervall T3-T2 im Wesentlichen gleich T2-T1 ist.

3. Messverfahren nach einem der Ansprüche 1 und 2, **dadurch gekennzeichnet, dass** das Zeitintervall T3-T2 im Wesentlichen gleich der Dauer des Messimpulses ist.

4. Messverfahren nach einem der Ansprüche 1 und 2, **dadurch gekennzeichnet, dass** das Zeitintervall T2-T1 im Wesentlichen gleich der Dauer des Messimpulses ist.

5. Messverfahren nach einem der Ansprüche 1 bis 4, **dadurch gekennzeichnet, dass** der Messimpuls ein Lichtimpuls ist und das Messsignal mittels eines Fotozellendetektors detektiert wird.

6. Messverfahren nach einem der Ansprüche 1 bis 5, **dadurch gekennzeichnet, dass** es auf Regendetektion auf der Windschutzscheibe eines Fahrzeugs angewandt wird, wobei der Messimpuls ein Lichtimpuls ist, der in Richtung auf die Windschutzscheibe emittiert und mit einem Reflexionskoeffizienten reflektiert wird, der von der An- oder Abwesenheit von Regen auf der Windschutzscheibe abhängig ist.

7. Messvorrichtung mit synchroner Detektion in Bezug auf einen Messimpuls, der eine vorübergehende Verstärkung eines zu messenden Signals bewirkt, die wenigstens eine Abtast-Halte-Schaltung mit Kommutationsmitteln (K1a, K'1a, K1b, K'1b, K2a, K'2a, K2b, K'2b) umfasst, die mit dem Messimpuls synchronisiert sind, um mithilfe der Abtast-Halte-Schaltung eine erste korrelierte Doppelabtastung zwischen einem unmittelbar vor dem Start des Messimpulses vorliegenden Zeitpunkt T1 und einem unmittelbar vor dem Ende des Messimpulses vorliegenden Zeitpunkt T2 durchzuführen, wobei diese Doppelabtastung ein Messsignal Vm zum Zeitpunkt T2 in Bezug auf einen Referenzpegel V1 zum Zeitpunkt T1 vor dem Start des Impulses ergibt, **dadurch gekennzeichnet, dass** die mit dem Messimpuls synchronisierten Kommutationsmittel angepasst sind, um eine zweite korrelierte Doppelabtastung zwischen dem Zeitpunkt T2 und einem Zeitpunkt T3 hinter dem Ende des Messimpulses zu bewirken, wobei diese zweite Abtastung eine Repräsentation der Messung des Signals Vm zum Zeitpunkt T2 in Bezug auf einen Referenzpegel V3 ergibt, die zum Zeitpunkt T3 hinter dem Ende des Impulses vorliegt, und dadurch, dass die Messvorrichtung Mittel zum Feststellen einer Differenz zwischen den von beiden Messungen stammenden Signalpegeln umfasst, wobei diese Differenz eine Repräsentation des Signalwertes Vm in Bezug auf einen Zwischenreferenzpegel zwischen den Referenzpegeln zu den Zeitpunkten T1 und T3 ist.

8. Vorrichtung nach Anspruch 7, **dadurch gekennzeichnet, dass** sie zwei Abtast-Halte-Schaltungen (ECH1, ECH2), die die Spannungspegel V1-Vm und Vm-V3 bereitstellen, und einen Subtrahierer am Ausgang der Abtastschaltungen umfasst, um die gewünchte Differenz zu erzeugen.

9. Vorrichtung nach Anspruch 7, **dadurch gekennzeichnet, dass** die Abtast-Halte-Schaltung differential ist und zwei Signaleingänge und einen Differentialverstärker (AMPa, AMPb) mit zwei Eingängen und zwei Ausgängen umfasst, wobei jeder Verstärkereingang mit einem ersten und einem zweiten Eingangskondensator (Cea1, Cea2; Ceb1, Ced2) assoziiert ist, die jeweils oberhalb dieses Eingangs platziert sind, und auch mit einem Integrationskondensator (Csa, Csb) assoziiert ist, der zwischen dem Eingang und einem entsprechenden Ausgang des Verstärkers geschaltet ist, wobei die Signaleingänge der mit den ersten Eingangskondensatoren verbundenen Abtastschaltung in Bezug auf die mit den zweiten Eingangskondensatoren verbundenen Signaleingängen überkreuzt sind; wobei die Kommutationsmittel Folgendes umfassen:

- Schalter (K1a, K'1a, K1b, K'1b) zum Betreiben der Abtast-Halte-Schaltung als korrelierte doppelte Abtast-Halte-Schaltung unter Verwendung der Integrationskondensatoren und der ersten Eingangskondensatoren durch anfängliches Anlegen, durch die ersten Eingangskondensatoren, einer Differentialeingangsspannung V1p-V1n, die das Referenzsignal V1 zum Zeitpunkt T1 repräsentiert, und durch nachfolgendes Anlegen einer Differentialeingangsspannung Vmp-Vmn, die das Messsignal Vm zum Zeitpunkt T2 repräsentiert,

- Schalter (K2a, K'2a, K2b, K'2b) zum Betreiben der Abtast-Halte-Schaltung als korrelierte doppelte Abtast-Halte-Schaltung unter Verwendung der Integrationskondensatoren und der zweiten Eingangskondensatoren durch anfängliches Anlegen, durch die zweiten Eingangskondensatoren, einer Differentialeingangsspannung Vmn-Vmp, die das entgegengesetzte -Vm des Messsignals zum Zeitpunkt T2 repräsentiert, und durch nachfolgendes Anlegen einer Differentialeingangsspannung V3n-V3p, die das entgegengesetzte -V3 des Referenzmesssignals zum Zeitpunkt T3 repräsentiert.

10. Vorrichtung nach Anspruch 9, **dadurch gekennzeichnet, dass** die Operationsverstärker mit einem Schalter (K"1a, K"1b) zum periodischen Entladen des Integrationskondensators ausgestattet sind.

11. Vorrichtung nach Anspruch 10, **dadurch gekennzeichnet, dass** ein Mittel (FL) zum periodischen Anlegen einer Spannung, die die Umkehr des Mittelwertes des Ausgangssignals der Differentialabtastschaltung repräsentiert, an einen Eingang jedes Operationsverstärkers vorgesehen ist.

12. Vorrichtung nach einem der Ansprüch 7 bis 11, **dadurch gekennzeichnet, dass** sie eine Emissionsfotozelle zum Emittieren eines Lichtimpulses umfasst, das den Messimpuls bildet, und einen Fotozellendetektor zum Zuführen des zu messenden Signals.

FIG.1

FIG.2

FIG.3

FIG.4

FIG.5

FIG.6

FIG.7

FIG.8

FIG.9

**EP 1 740 962 B1**

**Documents brevets cités dans la description**

- US 4262258 A